(19) Europäisches Patentamt
European Patent Office
Office européen des brevets

(11) **EP 2 448 127 A1**

(12) **EUROPEAN PATENT APPLICATION**
published in accordance with Art. 153(4) EPC

(43) Date of publication:
02.05.2012 Bulletin 2012/18

(21) Application number: 10791269.3

(22) Date of filing: 23.04.2010

(51) Int Cl.:
$H03M\ 13/27$ (2006.01)

(86) International application number:
PCT/CN2010/072164

(87) International publication number:
WO 2010/148763 (29.12.2010 Gazette 2010/52)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(30) Priority: 24.06.2009 CN 200910087635

(71) Applicant: ZTE Corporation
Shenzhen, Guangdong 518057 (CN)

(72) Inventor: XIAO, Shaoning
Shenzhen
Guangdong 518057 (CN)

(74) Representative: Guéné, Patrick
Cabinet Vidon
Technopôle Atalante
16B, rue de Jouanet
35703 Rennes Cedex 7 (FR)

(54) **CALCULATION METHOD AND DEVICE OF INTRA-TURBO CODE INTERLEAVER**

(57) A calculation method of a turbo code internal interleaver is disclosed by the present invention, and comprises: dividing a sequence with a length of $K_j$, which is input into a turbo code internal interleaver, into a plurality of windows each with a window length of $\Delta_j$, the window length $\Delta_j$ satisfying $2f_2\Delta_j$ (mod $K_j$) = 0, and $K_j$ being divided exactly by $\Delta_j$, wherein $f_2$ is a parameter dependent on $K_j$; obtaining output indices each of which corresponds to each input index in a first window; calculating successively output indices each of which corresponds to each input index in a rest window according to the output indices each of which corresponds to each input index in the first window. A calculation device of a turbo code internal interleaver is also disclosed by the present invention. With the present invention, the computational complexity of the turbo code internal interleaver can be reduced, so as to reduce the time delay of a specific calculation and save memory resources.

FIG. 1

Dividing a sequence with a length of $K_j$ into a plurality of windows each with a window length of $\Delta_j$ — 101

Obtaining output indices each of which corresponds to each input index in a first window — 102

calculating successively the output indices each of which corresponds to each input index in a rest window according to the output indices each of which corresponds to each input index in the first window — 103

EP 2 448 127 A1

**Description**

**Technical field**

The present invention relates to the Long Term Evolution (LTE) technology in the 3rd Generation Partnership Project (3GPP), particularly to a calculation method and device of turbo code internal interleaver in the LTE.

**Background**

The internal interleaver in a turbo code encoder or turbo code decoder uses Formula (1) to calculate an output index according to an input index:

$$\Pi(i) = \left( f_1 \cdot i + f_2 \cdot i^2 \right) \bmod K \qquad (1)$$

where $i$ is an input index and set to 0, 1, 2, ...... , $K$-1;

$\Pi(i)$ is an output index;

$f_1$ and $f_2$ are parameters dependent on K;

K is a length of an input sequence.

When Formula (1) is used in a turbo code encoder, the input sequence is a bit sequence; when it is used in a turbo code decoder, the input sequence is a soft bit sequence which refers to a non-binary sequence.
Further, the concrete values of $f_1$, $f_2$ and K may be obtained from the parameter table of a turbo code internal interleaver in 3GPP TS 36.212 Evolved Universal Terrestrial Radio Access (E-UTRA); Multiplexing and channel coding (Release 8) v8.5.0 (2008-12).
When prior art directly uses Formula (1) to calculate output index $\Pi(i)$, excessive modular arithmetic is involved, making the calculation very complex and thereby consuming excessive memory resources and resulting in a long time delay in implementation of the encoding process of a turbo code encoder or implementation of the decoding process of a turbo code decoder.

**Summary**

For this reason, the main object of the present invention is to provide a calculation method of a turbo code internal interleaver, which can reduce computational complexity, so as to save memory resources and reduce time delay.
To achieve the foregoing object, the technical solution of the present invention is realized in the following way.
A calculation method of a turbo code internal interleaver comprises:

dividing a sequence with a length of $K_j$, which is input into a turbo code internal interleaver, into a plurality of windows each with a window length of $\Delta_j$, the window length $\Delta_j$ satisfying $2f_2\Delta_j \pmod{K_j} = 0$, and $K_j$ being divided exactly by $\Delta_j$, wherein $f_2$ is a parameter dependent on $K_j$;

obtaining output indices each of which corresponds to each input index in a first window;

calculating successively output indices each of which corresponds to each input index in a rest window according to the output indices each of which corresponds to each input index in the first window.

A formula used for calculating the output indices each of which corresponds to each input index in the rest window may be:

$$\Pi\left(i + k \cdot \Delta_j\right) = \Pi\left(i\right) + [k \cdot \left(f_1 \cdot \Delta_j + f_2 \cdot \Delta_j^2\right)]\left(\bmod K_j\right)$$

where $i$ is an input index in the first window and set to 0, 1,2,...... , $\Delta_j$-1;

$$\frac{K_j}{\Delta_j} - 1$$

a value of $k$ is set to 1, 2,......, $\frac{K_j}{\Delta_j} - 1$ ;

$\Delta_j$ is window length;

$f_1$ and $f_2$ are parameters dependent on $K_j$;

$K_j$ is the length of the sequence.

A formula used for calculating the output indices each of which corresponds to each input index in the rest window may be:

$$\Pi\left(i + \Delta_j\right) = \Pi\left(i\right) + \left(f_1 \cdot \Delta_j + f_2 \cdot \Delta_j^2\right)\left(\bmod K_j\right)$$

where $i$ is an input index in a previous window and set to 0, 1, 2, ...... , $\Delta_j$-1;

$\Delta_j$ is window length;

$f_1$ and $f_2$ are parameters dependent on $K_j$;

$K_j$ is the length of the sequence.

The plurality of windows may refer to two or more windows.
The step of obtaining output indices each of which corresponds to each input index in the first window may refer to: reading from a memory or obtaining through calculation.
The step of obtaining output indices each of which corresponds to each input index in the first window through calculation may be calculating with a following formula:

$$\Pi(i) = \left(f_1 \cdot i + f_2 \cdot i^2\right) \bmod K_j$$

where $i$ is an input index and set to 0, 1, 2,...... , $K_j$-1.
The sequence may be a bit sequence or a soft bit sequence.
A calculation device of a turbo code internal interleaver comprises:

a window setting module, for dividing a sequence with a length of $K_j$, which is input into a turbo code internal interleaver, into a plurality of windows each with a window length of $\Delta_j$, the window length $\Delta_j$ satisfying $2f_2\Delta_j$ (mod $K_j$) = 0, and $K_j$ being divided exactly by $\Delta_j$, wherein $f_2$ is a parameter dependent on $K_j$;

a first output index obtaining module, for obtaining output indices each of which corresponds to each input index in a first window; and

a second output index obtaining module, for calculating successively output indices each of which corresponds to each input index in a rest window according to the output indices each of which corresponds to each input index in the first window.

The first output index obtaining module may be specifically used for reading from a memory or obtaining through calculation the output indices each of which corresponds to each input index in the first window.
The plurality of windows may refer to two or more windows; and/or
the sequence may be a bit sequence or a soft bit sequence.
From the foregoing technical solution, it may be known that by dividing a sequence with a length of $K_j$ into a

plurality of windows each with a window length of $\Delta_j$, and making the window length $\Delta_j$ satisfy $2f_2\Delta_j \,(\text{mod } K_j) = 0$ and $K_j$ divided exactly by $\Delta_j$, starting from the second window, the present invention can obtain through calculation the output indices each of which corresponds to each input index in each window according to the output indices each of which corresponds to each input index in the first window. The modular arithmetic involved in this method is very simple, therefore the method can significantly reduce the computational complexity of the turbo code internal interleaver, thereby saving the memory resources used for this computation. In other words, it may reduce the memory area used for this computation, thereby reducing cost. Further, the output indices obtained through calculation are used for a turbo code encoder or turbo code decoder. As the computational complexity of the turbo code internal interleaver is reduced, the time delay in the implementation of the entire encoding process of a turbo code encoder or in the implementation of the entire decoding process of a turbo code decoder is reduced; thus, the present invention can save the cost and time delay of the whole system.

**Brief description of the drawings**

FIG. 1 is a schematic diagram showing a flow of a calculation method of a turbo code internal interleaver according to the present invention;

FIG. 2 is a schematic diagram showing a structure of a calculation device of a turbo code internal interleaver according to the present invention.

**Detailed description**

Before detailed description of a calculation method of a turbo code internal interleaver according to the present invention, the principle of this calculation method is introduced.

Firstly, a bit sequence or soft bit sequence with a length of $K_j$, which is input into the turbo code internal interleaver, is divided into a plurality of segments which have a same length. Each segment is called a window. It is supposed that the length of each window is $\Delta_j$, an input index of an element a in window n is $i$, and an output index after $i$ is interleaved with Formula (1) is $\Pi(i)$ ; in window n+1, the input index of element b with a distance of $\Delta_j$ from element a is $i+\Delta_j$, and the output index after $i+\Delta_j$ is interleaved with Formula (1) is $\Pi(i+\Delta_j)=[f_1(i+\Delta_j)+f_2(i+\Delta_j)^2](\text{mod}K_j)$.

Successively, the following equation may be obtained:

$$\Pi\left(i+\Delta_j\right)-\Pi\left(i\right)$$
$$=[f_1\cdot\left(i+\Delta_j\right)+f_2\cdot\left(i+\Delta_j\right)^2-f_1\cdot i-f_2\cdot i^2]\left(\text{mod } K_j\right)$$
$$=[f_1\cdot\Delta_j+f_2\cdot\Delta_j^{\,2}+2f_2\Delta_j i]\left(\text{mod } K_j\right)$$

From the foregoing equation, it may be known that if $2f_2\Delta_j(\text{mod}K_j)=0$, then $2f_2\Delta_j i(\text{mod } K_j)=0$ , and Formula (2) may be obtained:

$$\Pi\left(i+\Delta_j\right)=\Pi\left(i\right)+[f_1\cdot\Delta_j+f_2\cdot\Delta_j^{\,2}]\left(\text{mod } K_j\right) \qquad (2)$$

i.e., $\Pi(i+\Delta_j)=\Pi(i)+$ Constant independent of $i$ (mod $K_j$).

Therefore, if window length $\Delta_j$ can satisfy $2f_2\Delta_j\,(\text{mod } K_j) = 0$ , then an output index of an element in a subsequent window may be easily calculated based on the output index of the element in the first window.

In fact, according to the parameter table of the turbo code internal interleaver, for every $K_j$, an appropriate $\Delta_j$ can be obtained to make $2f_2\Delta_j\,(\text{mod } K_j)=0$ and $K_j$ divided exactly by $\Delta_j$. According to the parameter table of the turbo code internal interleaver, the range of $j$ is 1, 2, 3, ...... , 188.

For example, $K_j=40$, $f_1=3$, $f_2=10$, to make $2\times10\times\Delta_j \bmod 40=0$ and 40 divided exactly by $\Delta_j$, $\Delta_j$ may be set to 20. Here, the value of $\Delta_j$ is not exclusive as long as $2f_2\Delta_j\,(\text{mod } K_j) = 0$ is satisfied and $K_j$ is divided exactly by $\Delta_j$. For example, $\Delta_j$ may be 2 or 4.

Therefore, from the foregoing example, it may be known that for different $K_j$, as long as $2f_2\Delta_j\,(\text{mod } K_j) = 0$ is

satisfied and $K_j$ is divided exactly by $\Delta_j$, $\Delta_j$ may be set to different values.

Here, those skilled in the art may know why $\Delta_j$ needs to satisfy the condition that $K_j$ is divided exactly by $\Delta_j$ in addition to satisfying the condition of $2f_2\Delta_j \pmod{K_j} = 0$.

This is because all windows should have a same length and the number of windows should be an integer.

From Formula (2), Formula (3) may be deduced:

$$\Pi\left(i + k \cdot \Delta_j\right) = \Pi\left(i\right) + [k \cdot \left(f_1 \cdot \Delta_j + f_2 \cdot \Delta_j^2\right)]\left(\operatorname{mod} K_j\right) \qquad (3)$$

where $i$ is an input index in the first window and set to 0, 1,2,...... , $\Delta_j$-1; the value of $k$ is set to 1, 2, ...... , $\dfrac{K_j}{\Delta_j} - 1$ .

When $k$=1, it means the output indices each of which corresponds to eac input index in the second window is calculated based on the output indices $\Pi(i)$ each of which corresponds to each input index $i$ in the first window. When $k$ is another value, the rest may be deduced by analogy.

Below the technical solution of the present invention is described in details.

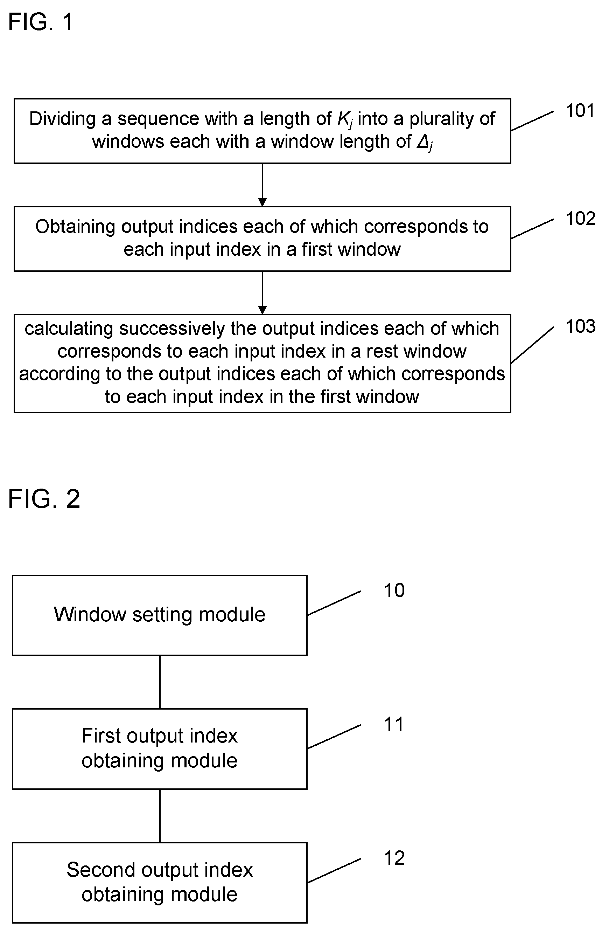

As shown in FIG. 1, a calculation method of a turbo code internal interleaver according to the present invention comprises the following steps.

S101, dividing a sequence with a length of $K_j$, which is input into the turbo code internal interleaver, into a plurality of windows each with a window length of $\Delta_j$, the window length $\Delta_j$ satisfying $2f_2\Delta_j \pmod{K_j} = 0$ , and $K_j$ being divided exactly by $\Delta_j$, wherein $f_2$ is a parameter dependent on $K_j$.

The sequence is a bit sequence or soft bit sequence; the soft bit sequence refers to a non-binary sequence.

The plurality of windows refers to two or more windows.

S102, obtaining output indices each of which corresponds to each input index in a first window.

When a memory stores pre-calculated output indices each of which corresponds to each input index in the first window, then the output indices each of which corresponds to each input index in the first window may be directly read from the memory, or obtained through calculation with Formula (1).

S103, calculating successively the output indices each of which corresponds to each input index in a rest window according to the output indices each of which corresponds to each input index in the first window.

The so-called "successively" refers to: calculating the output indices each of which corresponds to each input index in a window at first, and then calculating the output indices each of which corresponds to each input index in a next window.

The actual calculation formula may be Formula (3) as described above:

$$\Pi\left(i + k \cdot \Delta_j\right) = \Pi\left(i\right) + [k \cdot \left(f_1 \cdot \Delta_j + f_2 \cdot \Delta_j^2\right)]\left(\operatorname{mod} K_j\right) \qquad (3)$$

where $i$ is an input index in the first window and set to 0, 1,2, ...... , $\Delta_j$-1; the value of $k$ is set to 1, 2, ...... , $\dfrac{K_j}{\Delta_j} - 1$

$\Delta_j$ is window length;
$f_1$ and $f_2$ are parameters dependent on $K_j$;
$K_j$ is the length of the sequence.

Alternatively, Formula (4) may be adopted for the calculation, i.e. calculating the output indices each of which corresponds to each input index in a next window according to the output indices each of which corresponds to each input index in a previous window.

$$\Pi\left(i + \Delta_j\right) = \Pi\left(i\right) + \left(f_1 \cdot \Delta_j + f_2 \cdot \Delta_j^2\right)\left(\operatorname{mod} K_j\right) \qquad (4)$$

where $i$ is an input index in the previous window and set to 0, 1,2,...... , $\Delta_j$-1;
$\Delta_j$ is window length;

$f_1$ and $f_2$ are parameters dependent on $K_j$;
$K_j$ is the length of the sequence.

In the following parameter matrix of the turbo code internal interleaver, the first column is $K_j$, the second column is $f_1$, the third column is $f_2$, and the fourth column is $\Delta_j$

interleave_matrix = ...

| | | | |
|---|---|---|---|
| [403 | 10 | 20; | |
| 48 7 | 12 | 16; | |
| 56 19 | 42 | 28; | |
| 64 7 | 16 | 64; | |
| 72 7 | 18 | 36; | |
| 80 11 | 20 | 40; | |
| 88 5 | 22 | 22; | |
| 96 11 | 24 | 32; | |
| 104 | 7 | 26 | 26; |
| 112 | 41 | 84 | 16; |
| 120 | 103 | 90 | 8; |
| 128 | 15 | 32 | 32; |
| 136 | 9 | 34 | 8; |
| 144 | 17 | 108 | 16; |
| 152 | 9 | 38 | 8; |
| 160 | 21 | 120 | 32; |
| 168 | 101 | 84 | 24; |
| 176 | 21 | 44 | 16; |
| 184 | 57 | 46 | 8; |
| 192 | 23 | 48 | 32; |
| 200 | 13 | 50 | 8; |
| 208 | 27 | 52 | 16; |
| 216 | 11 | 36 | 27; |
| 224 | 27 | 56 | 32; |
| 232 | 85 | 58 | 8; |
| 240 | 29 | 60 | 16; |
| 248 | 33 | 62 | 8; |
| 256 | 15 | 32 | 32; |
| 264 | 17 | 198 | 8; |
| 272 | 33 | 68 | 8; |
| 280 | 103 | 210 | 8; |
| 288 | 19 | 36 | 32; |
| 296 | 19 | 74 | 296; |
| 304 | 37 | 76 | 16; |
| 312 | 19 | 78 | 8; |
| 320 | 21 | 120 | 16; |
| 328 | 21 | 82 | 8; |
| 336 | 115 | 84 | 16; |
| 344 | 193 | 86 | 8; |
| 352 | 21 | 44 | 32; |
| 360 | 133 | 90 | 8; |
| 368 | 81 | 46 | 16; |
| 376 | 45 | 94 | 8; |
| 384 | 23 | 48 | 8; |
| 392 | 243 | 98 | 8; |
| 400 | 151 | 40 | 10; |
| 408 | 155 | 102 | 8; |
| 416 | 25 | 52 | 8; |

(continued)

| | | | |
|---|---|---|---|
| 424 | 51 | 106 | 8; |
| 432 | 47 | 72 | 12; |
| 440 | 91 | 110 | 8; |
| 448 | 29 | 168 | 64; |
| 456 | 29 | 114 | 8; |
| 464 | 247 | 58 | 16; |
| 472 | 29 | 118 | 8; |
| 480 | 89 | 180 | 32; |
| 488 | 91 | 122 | 8; |
| 496 | 157 | 62 | 16; |
| 504 | 55 | 84 | 24; |
| 512 | 31 | 64 | 32; |
| 528 | 17 | 66 | 16; |
| 544 | 35 | 68 | 32; |
| 560 | 227 | 420 | 16; |
| 576 | 65 | 96 | 12; |
| 592 | 19 | 74 | 16; |
| 608 | 37 | 76 | 32; |
| 624 | 41 | 234 | 16; |
| 640 | 39 | 80 | 16; |
| 656 | 185 | 82 | 16; |
| 672 | 43 | 252 | 32; |
| 688 | 21 | 86 | 16; |
| 704 | 155 | 44 | 64; |
| 720 | 79 | 120 | 48; |
| 736 | 139 | 92 | 32; |
| 752 | 23 | 94 | 16; |
| 768 | 217 | 48 | 64; |
| 784 | 25 | 98 | 16; |
| 800 | 17 | 80 | 40; |
| 816 | 127 | 102 | 16; |
| 832 | 25 | 52 | 64; |
| 848 | 239 | 106 | 16; |
| 864 | 17 | 48 | 36; |
| 880 | 137 | 110 | 16; |
| 896 | 215 | 112 | 64; |
| 912 | 29 | 114 | 16; |
| 928 | 15 | 58 | 32; |
| 944 | 147 | 118 | 16; |
| 960 | 29 | 60 | 64; |
| 976 | 59 | 122 | 16; |
| 992 | 65 | 124 | 32;; |
| 1008 | 55 | 84 | 48; |
| 1024 | 31 | 64 | 64; |
| 1056 | 17 | 66 | 32; |
| 1088 | 171 | 204 | 64; |
| 1120 | 67 | 140 | 32; |
| 1152 | 35 | 72 | 32; |
| 1184 | 19 | 74 | 32; |
| 1216 | 39 | 76 | 64; |
| 1248 | 19 | 78 | 32; |

(continued)

| | | | |
|---|---|---|---|
| 1280 | 199 | 240 | 32; |
| 1312 | 21 | 82 | 32; |
| 1344 | 211 | 252 | 64; |
| 1376 | 21 | 86 | 32; |
| 1408 | 43 | 88 | 64; |
| 1440 | 149 | 60 | 96; |
| 1472 | 45 | 92 | 64; |
| 1504 | 49 | 846 | 32; |
| 1536 | 71 | 48 | 64; |
| 1568 | 13 | 28 | 28; |
| 1600 | 17 | 80 | 20; |
| 1632 | 25 | 102 | 32; |
| 1664 | 183 | 104 | 64; |
| 1696 | 55 | 954 | 32; |
| 1728 | 127 | 96 | 36; |
| 1760 | 27 | 110 | 32; |
| 1792 | 29 | 112 | 64; |
| 1824 | 29 | 114 | 32; |
| 1856 | 57 | 116 | 64; |
| 1888 | 45 | 354 | 32; |
| 1920 | 31 | 120 | 64; |
| 1952 | 59 | 610 | 32; |
| 1984 | 185 | 124 | 64; |
| 2016 | 113 | 420 | 48; |
| 2048 | 31 | 64 | 64; |
| 2112 | 17 | 66 | 64; |
| 2176 | 171 | 136 | 64; |
| 2240 | 209 | 420 | 64; |
| 2304 | 253 | 216 | 64; |
| 2368 | 367 | 444 | 64; |
| 2432 | 265 | 456 | 64; |
| 2496 | 181 | 468 | 64; |
| 2560 | 39 | 80 | 64; |
| 2624 | 27 | 164 | 64; |
| 2688 | 127 | 504 | 64; |
| 2752 | 143 | 172 | 64; |
| 2816 | 43 | 88 | 64; |
| 2880 | 29 | 300 | 24; |
| 2944 | 45 | 92 | 64; |
| 3008 | 157 | 188 | 64; |
| 3072 | 47 | 96 | 64; |
| 3136 | 13 | 28 | 56; |
| 3200 | 111 | 240 | 60; |
| 3264 | 443 | 204 | 64; |
| 3328 | 51 | 104 | 64; |
| 3392 | 51 | 212 | 64; |
| 3456 | 451 | 192 | 72; |
| 3520 | 257 | 220 | 64; |
| 3584 | 57 | 336 | 64; |
| 3648 | 313 | 228 | 64; |
| 3712 | 271 | 232 | 64; |

(continued)

| | | | |
|---|---|---|---|
| 3776 | 179 | 236 | 64; |
| 3840 | 331 | 120 | 64; |
| 3904 | 363 | 244 | 64; |
| 3968 | 375 | 248 | 64; |
| 4032 | 127 | 168 | 36; |
| 4096 | 31 | 64 | 64; |
| 4160 | 33 | 130 | 64; |
| 4224 | 43 | 264 | 64; |
| 4288 | 33 | 134 | 64; |
| 4352 | 477 | 408 | 64; |
| 4416 | 35 | 138 | 64; |
| 4480 | 233 | 280 | 64; |
| 4544 | 357 | 142 | 64; |
| 4608 | 337 | 480 | 72; |
| 4672 | 37 | 146 | 64; |
| 4736 | 71 | 444 | 64; |
| 4800 | 71 | 120 | 60; |
| 4864 | 37 | 152 | 64; |
| 4928 | 39 | 462 | 64; |
| 4992 | 127 | 234 | 64; |
| 5056 | 39 | 158 | 64; |
| 5120 | 39 | 80 | 64; |
| 5184 | 31 | 96 | 54; |
| 5248 | 113 | 902 | 64; |
| 5312 | 41 | 166 | 64; |
| 5376 | 251 | 336 | 64; |
| 5440 | 43 | 170 | 64; |
| 5504 | 21 | 86 | 64; |
| 5568 | 43 | 174 | 64; |
| 5632 | 45 | 176 | 64; |
| 5696 | 45 | 178 | 64; |
| 5760 | 161 | 120 | 24; |
| 5824 | 89 | 182 | 64; |
| 5888 | 323 | 184 | 64; |
| 5952 | 47 | 186 | 64; |
| 6016 | 23 | 94 | 64; |
| 6080 | 47 | 190 | 64; |
| 6144 | 263 | 480 | 64]; |

The above parameter matrix of the turbo code internal interleaver lists the reasonable values of $\Delta_j$ in real application.

Below the technical solution of the present invention is further described in combination with an embodiment.

When the length $K_j$ of a bit sequence, which is input into the turbo code internal interleaver, is 6144, it may be known from the parameter table of the turbo code internal interleaver that $f_1$=263, $f_2$=480. According to the condition that window length $\Delta_j$ needs to satisfy $2f_2\Delta_j \pmod{K_j} = 0$ and $K_j$ is divided exactly by $\Delta_j$, window length is set to $\Delta_j$ =64, then there will be 6144/64=96 windows.

64 is not the only value of window length $\Delta_j$, but is used here as an example only.

The output indices each of which corresponds to each input index in the first window are read from the memory or obtained through calculation with Formula (1).

The input index $i$ in the first window is 0, 1, 2, ...... , 63.

Supposing $k$=1, the output indices each of which corresponds to each input index in the second window are calculated with Formula (3).

The formula used to calculate the output indices each of which corresponds to each input index in the second window is:

$$\Pi(i+64)$$
$$= \Pi(i) + \left(263 \times 64 + 480 \times 64^2\right)(\bmod\, 6144)$$
$$= \Pi(i) + 4544$$

Next, the output indices each of which corresponds to each input index in the rest windows are successively calculated with Formula (3).

In this embodiment, except the first window, the general formula used for calculating the output indices each of which corresponds to each input index in the rest windows is:

$$\Pi(i + k \cdot 64)$$
$$= \Pi(i) + [k \cdot \left(263 \times 64 + 480 \times 64^2\right)](\bmod\, 6144)$$
$$= \Pi(i) + (k \cdot 4544)(\bmod\, 6144)$$

where k is set to 1, 2, 3, ......, 95.

From the above analysis, it may be known that when the present invention calculates the output indices each of which corresponds to each input index in a window, the modular arithmetic involved is very simple, so compared with the prior art, the present invention significantly reduces the computational complexity of the turbo code internal interleaver.

To realize the foregoing method, the present invention provides a calculation device of the turbo code internal interleaver accordingly, as shown in FIG. 2. This calculation device comprises:

a window setting module 10, for dividing a sequence with a length of $K_j$, which is input into the turbo code internal interleaver, into a plurality of windows each with a window length of $\Delta_j$, the window length $\Delta_j$ satisfying $2 f_2 \Delta_j$ (mod $K_j$) = 0, and $K_j$ being divided exactly by $\Delta_j$, wherein $f_2$ is a parameter dependent on $K_j$;

a first output index obtaining module 11, for obtaining output indices each of which corresponds to each input index in a first window, and the output indices in the first window may be read from a memory or obtained through calculation; and

a second output index obtaining module 12, for calculating successively output indices each of which corresponds to each input index in a rest window according to the output indices each of which corresponds to each input index in the first window.

The first output index obtaining module 11 is specifically used for reading from the memory or obtaining through calculation the output indices each of which corresponds to each input index in the first window.

The plurality of windows refers to two or more windows.

The sequence is a bit sequence or a soft bit sequence.

The foregoing description is a preferred embodiment of the present invention and is not intended to limit the protection scope of the present invention.

## Claims

1.   A calculation method of a turbo code internal interleaver, comprising:

dividing a sequence with a length of $K_j$, which is input into a turbo code internal interleaver, into a plurality of windows each with a window length of $\Delta_j$, the window length $\Delta_j$ satisfying $2 f_2 \Delta_j$ (mod $K_j$) = 0, and $K_j$ being divided exactly by $\Delta_j$, wherein $f_2$ is a parameter dependent on $K_j$;
obtaining output indices each of which corresponds to each input index in a first window;
calculating successively output indices each of which corresponds to each input index in a rest window according to the output indices each of which corresponds to each input index in the first window.

2. The method according to claim 1, wherein a formula used for calculating the output indices each of which corresponds to each input index in the rest window is:

$$\Pi\left(i+k\cdot\Delta_{j}\right)=\Pi\left(i\right)+[k\cdot\left(f_{1}\cdot\Delta_{j}+f_{2}\cdot\Delta_{j}^{2}\right)]\left(\operatorname{mod}K_{j}\right)$$

where $i$ is an input index in the first window and set to 0, 1, 2, ...... , $\Delta_j$-1;

a value of $k$ is set to 1, 2, ...... $\dfrac{K_j}{\Delta_j}-1$ ,

$\Delta_j$ is window length;
$f_1$ and $f_2$ are parameters dependent on $K_j$;
$K_j$ is the length of the sequence.

3. The method according to claim 1, wherein a formula used for calculating the output indices each of which corresponds to each input index in the rest window is:

$$\Pi\left(i+\Delta_{j}\right)=\Pi\left(i\right)+\left(f_{1}\cdot\Delta_{j}+f_{2}\cdot\Delta_{j}^{2}\right)\left(\operatorname{mod}K_{j}\right)$$

where $i$ is an input index in a previous window and set to 0, 1, 2, ...... , $\Delta_j$-1;
$\Delta_j$ is window length;
$f_1$ and $f_2$ are parameters dependent on $K_j$;
$K_j$ is the length of the sequence.

4. The method according to any of claims 1 to 3, wherein the plurality of windows refers to two or more windows.

5. The method according to any of claims 1 to 3, wherein the step of obtaining output indices each of which corresponds to each input index in the first window, refers to: reading from a memory or obtaining through calculation.

6. The method according to claim 5, wherein the step of obtaining output indices each of which corresponds to each input index in the first window through calculation is calculating with a following formula:

$$\Pi(i)=\left(f_{1}\cdot i+f_{2}\cdot i^{2}\right)\operatorname{mod}K_{j}$$

where $i$ is an input index and set to 0, 1, 2, ...... , $K_j$-1.

7. The method according to any of claims 1 to 3, wherein the sequence is a bit sequence or a soft bit sequence.

8. A calculation device of a turbo code internal interleaver, comprising:

a window setting module, for dividing a sequence with a length of $K_j$, which is input into a turbo code internal interleaver, into a plurality of windows each with a window length of $\Delta_j$, the window length $\Delta_j$ satisfying $2f_2\Delta_j$ (mod $K_j$) = 0 , and $K_j$ being divided exactly by $\Delta_j$, wherein $f_2$ is a parameter dependent on $K_j$;
a first output index obtaining module, for obtaining output indices each of which corresponds to each input index in a first window; and
a second output index obtaining module, for calculating successively output indices each of which corresponds to each input index in a rest window according to the output indices each of which corresponds to each input index in the first window.

9. The device according to claim 8, wherein the first output index obtaining module is specifically used for reading from a memory or obtaining through calculation the output indices each of which corresponds to each input index in the first window.

**10.** The device according to claim 8 or 9, wherein
the plurality of windows refers to two or more windows; and/or
the sequence is a bit sequence or a soft bit sequence.

FIG. 1

Dividing a sequence with a length of $K_j$ into a plurality of windows each with a window length of $\Delta_j$ — 101

Obtaining output indices each of which corresponds to each input index in a first window — 102

calculating successively the output indices each of which corresponds to each input index in a rest window according to the output indices each of which corresponds to each input index in the first window — 103

FIG. 2

Window setting module — 10

First output index obtaining module — 11

Second output index obtaining module — 12

# INTERNATIONAL SEARCH REPORT

| International application No. |
| --- |
| PCT/CN2010/072164 |

**A. CLASSIFICATION OF SUBJECT MATTER**

H03M 13/27 (2006.01) i

According to International Patent Classification (IPC) or to both national classification and IPC

**B. FIELDS SEARCHED**

Minimum documentation searched (classification system followed by classification symbols)

IPC: H03M, H04L

Documentation searched other than minimum documentation to the extent that such documents are included in the fields searched

Electronic data base consulted during the international search (name of data base and, where practicable, search terms used)

**WPI; EPODOC; CPRS; CNKI:**

Turbo, interleav+, window, block, segment+, part, length, quadratic permutation polynomial, quadratic polynomial permutation, QPP

**C. DOCUMENTS CONSIDERED TO BE RELEVANT**

| Category* | Citation of document, with indication, where appropriate, of the relevant passages | Relevant to claim No. |
| --- | --- | --- |
| X | WO2009070440A1 (MOTOROLA INC) 04 Jun. 2009 (04.06.2009) specification page 7 paragraph [34]- page 28 paragraph [124], and figs.4-17 | 1, 4-10 |
| A | US20080205636A1 (Nimbalker et al.) 28 Aug. 2008 (28.08.2008) See the whole document | 1-10 |
| A | WO2008067149A2 (MOTOROLA INC) 05 Jun. 2008 (05.06.2008) See the whole document | 1-10 |
| A | CN101034951A (ZTE COMMUNICATION CO LTD) 12 Sep. 2007 (12.09.2007) See the whole document | 1-10 |

☐ Further documents are listed in the continuation of Box C.  ☒ See patent family annex.

| | |
| --- | --- |
| \*      Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim (S) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&" document member of the same patent family |

| Date of the actual completion of the international search | Date of mailing of the international search report |
| --- | --- |
| 21 Jul. 2010 (21.07.2010) | **05 Aug. 2010 (05.08.2010)** |

| Name and mailing address of the ISA/CN | Authorized officer |
| --- | --- |
| The State Intellectual Property Office, the P.R.China 6 Xitucheng Rd., Jimen Bridge, Haidian District, Beijing, China 100088 Facsimile No. 86-10-62019451 | **WEN,Rui** Telephone No. (86-10)6241 2083 |

Form PCT/ISA /210 (second sheet) (July 2009)

## INTERNATIONAL SEARCH REPORT
### Information on patent family members

International application No.

PCT/CN2010/072164

| Patent Documents referred in the Report | Publication Date | Patent Family | Publication Date |
|---|---|---|---|
| WO2009070440A1 | 04.06.2009 | US20090138668A1 | 28.05.2009 |
| US20080205636A1 | 28.08.2008 | WO2008106320A1 | 04.09.2008 |
| | | JP2008219892A | 18.09.2008 |
| | | TW200845593A | 16.11.2008 |
| | | EP2119017A1 | 18.11.2009 |
| | | INCHENP200904566E | 02.10.2009 |
| | | KR20090127878A | 14.12.2009 |
| | | MXPA09009143A | 30.09.2009 |
| | | CN101636914A | 27.01.2010 |
| WO2008067149A2 | 05.06.2008 | US20080133998A1 | 05.06.2008 |
| | | JP2008141756A | 19.06.2008 |
| | | WO2008067149A3 | 28.08.2008 |
| | | WO2008067149B1 | 09.10.2008 |
| | | INKOLNP200901082E | 22.05.2009 |
| | | KR20090094262A | 04.09.2009 |
| | | EP2102989A2 | 23.09.2009 |
| | | CN101601188A | 09.12.2009 |
| CN101034951A | 12.09.2007 | None | |

Form PCT/ISA /210 (patent family annex) (July 2009)